# EUROPEAN PATENT APPLICATION

(11) **EP 3 582 008 A1**
(43) Date of publication of application: **18.12.2019**
(21) Application number: 18177981.0
(22) Date of filing: 15.06.2018
(51) Int. Cl.: G03F 7/20

(54) **EXPOSURE ARRANGEMENT FOR AN ADDITIVE MANUFACTURING SYSTEM, ADDITIVE MANUFACTURING SYSTEM AND METHOD OF MANUFACTURING AN OBJECT**

(71) Applicant: Nederlandse Organisatie voor toegepast- natuurwetenschappelijk onderzoek TNO, 2595 DA 's-Gravenhage (NL)
(72) Inventor: Smeltink, Jeroen Anthonius, 2595 DA 's-Gravenhage (NL); van Zwet, Erwin JOhn, 2595 DA 's-Gravenhage (NL)
(74) Representative: V.O.

(57) **Abstract**

The present document describes an exposure arrangement for an additive manufacturing system, the exposure arrangement comprising a radiation source configured for providing a radiation beam, a digital micromirror device comprising a mirror array including a plurality of controllable mirrors, and one or more optical elements for directing radiation from the digital micromirror device towards a surface of building material in use. The digital micromirror device is configured for receiving the radiation beam, and wherein the digital micromirror device is configured for forming, by the controllable mirrors, a plurality of illumination beams for illuminating the building material for forming a plurality of voxels, for at least partially curing, melting or sintering the building material in each of the voxels. The arrangement further comprises a lens array between the one or more optical elements and a location of the surface of building material in use, the lens array being arranged such as to be located opposite the surface of building material, wherein the lens array comprises a plurality of lenslets and wherein each lenslet is configured for focusing at least one of the illumination beams onto the surface, for forming the voxels. The document further describes a method of manufacturing an object.

## Description

### Field of the invention

The present invention is directed at an exposure arrangement for an additive manufacturing system, the exposure arrangement comprising a radiation source configured for providing a radiation beam. The invention is further directed at an additive manufacturing system comprising an exposure arrangement, and further at a method of manufacturing an object using an exposure system.

### Background

In powder bed fusion systems, such as selective laser sintering or selective laser melting, the time to build an object is greatly influenced by the time required to sinter or melt the building material. The sintering or melting is typically performed using a laser in combination with a galvanometer scanner. Although galvanometer scanners are very accurate for this purpose, they unfortunately deliver a low performance in terms of speed.

To overcome this disadvantage, efforts have been made to develop laser line scanners for additive manufacturing system such as the one referred to above. Such systems comprise optics to produce a laser line with which the surface may be scanned in one pass. The scanning may thus be performed much faster. Although such line scanners for this purpose are fully in development, such systems are rather expensive, while delivering a relatively small amount of power per pixel and a coarse resolution.

### Summary of the invention

It is an object of the present invention to provide an exposure system that is useable in an additive manufacturing system or process, which alleviates the above drawbacks of conventional systems, and which provide for high performance scanning while delivering sufficient power per pixel at high resolution.

To this end, there is provided herewith an exposure arrangement for an additive manufacturing system, the exposure arrangement comprising a radiation source configured for providing a radiation beam, a digital micromirror device comprising a mirror array including a plurality of controllable mirrors, and one or more optical elements for directing radiation from the digital micromirror device towards a surface of building material in use; wherein the digital micromirror device is configured for receiving the radiation beam, and wherein the digital micromirror device is configured for forming, by the controllable mirrors, a plurality of illumination beams for illuminating the building material for forming a plurality of voxels, for at least partially curing, melting or sintering the building material in each of the voxels; wherein the arrangement further comprises a lens array between the one or more optical elements and a location of the surface of building material in use, the lens array being arranged such as to be located opposite the surface of building material, wherein the lens array comprises a plurality of lens lets and wherein each lens let is configured for focusing at least one of the illumination beams onto the surface, for forming the voxels.

The exposure arrangement of the invention uses a digital micromirror device (DMD) to split a radiation beam from a radiation source (such as a laser) into a plurality of illumination beams (here referred to as 'illumination beams' to distinguish from the 'radiation beam'). The illumination beams formed are directed to the lens array and thereafter focused into a plurality of focal points by the lens lets of the lens array, thereby achieving high resolution at a sufficiently high power per pixel. This may be used to perform curing, or alternatively to perform melting or sintering in a similar type of application. Advantageously, the components of such an exposure system are low cost and comprise a flat form factor. This provides for a low cost, high performance and high resolution system, with the additional advantage of being small sized.

Moreover, the use of a DMD in combination with a lens array enables scaling of the system. DMD's may consist of thousands of mirrors; the beams from multiple mirrors may be focused by a single lenslet of the lens array. By increasing or reducing the aperture of each lens let, the number of mirrors of which the illumination beams are focused by a same lens let likewise changes, and therewith, the amount of power received per pixel per unit of time. In accordance with an embodiment, the digital micromirror device is configured for forming each of the illumination beams by radiation from one of the controllable mirrors, and providing each lens let of the lens array with a plurality of the illumination beams.

The radiation source applied may be any kind of laser or laser diode. Good results have been achieved using a multimode laser diode for this purpose. These elements provide high power and are relatively low cost. In some embodiments, the radiation source is a multimode laser, such as a multimode laser diode, having an optical output power between 100 milliwatt and 10 kilowatt; preferably between 1 watt and 1 kilowatt; more preferably between 50 watt and 500 watt. For example, multimode laser diodes may deliver powers of 10 W, 20 W, 30 W, 40 W, 50 W, 55 W, 70 W, 80 W, 150 W 200 W, 300 W, 500 W or even more, while still maintaining a small form factor and being relatively low priced.

In some embodiments, the exposure arrangement further comprises one or more optical fibers, wherein the radiation source is coupled to the or each optical fiber for providing the radiation beam to the or each optical fiber, and wherein the or each optical fiber is arranged for directing the radiation beam to the digital micromirror device. Although laser diodes, such as multimode laser diodes, are relatively small, they may still be larger than a DMD in combination with a lens array in accordance with the present invention. Therefore, fibers may be used for directing the radiation towards the DMD without requiring space for placing the radiation source near the DMD. The exposure arrangement of the invention may therefore be placed much closer to the substrate surface, which is advantageous for many different reasons.

The lens array, in accordance with some embodiments, may be mounted in the arrangement such as to be replaceable, for enabling replacing of the lens array by a further lens array to enable adapting a resolution of the exposure arrangement. Replacing the lens array by a different one having lenses with a different aperture, optionally in combination with replacing of some secondary optics, causes these lenses to receive a different number of illumination beams. Likewise, the resolution is determined by the number of lens lets per area. This causes the resolution to become adaptable, which is a great advantage of the exposure arrangement of the invention.

In some embodiments, the controllable mirrors of the digital micromirror device are controllable by controlling one or more of the controllable mirrors for switching the mirrors off and on in a dark or reflective state.

In accordance with some embodiments, the exposure arrangement further comprises a controller configured for controlling at least one of the digital micromirror device, the radiation source, one or more mirrors of the digital micromirror device, or one or more actuators for positioning of at least one of the digital micromirror device, the radiation source or the lens array. The exposure head of the present invention, in some embodiments, optionally comprises such actuators in order to perform controlled adjustments to the optics by controlling the one or more actuators. Such actuators allow to adjust relative positioning of the DMD, the lens array, the radiation source or the fiber ends of the fibers in some embodiments. With respect to the DMD, the controller may be configured to control the switching of the mirrors in a dark or reflective state, as mentioned herein above. Other operational parameters of the DMD may likewise be controlled via the controller. The above may advantageously be used to improve the quality of the beam with respect to the requirements of the application. Moreover, controlling may be applied to perform stitching between different of subsequent exposure heads, such as to perform exposure over a larger area with multiple exposure heads and/or multiple passes.

In accordance with some preferred embodiments, the arrangement further comprises a sensor system for monitoring the surface of the building material, the exposure arrangement further comprising a partially transparent mirror arranged between the digital micromirror device and the one or more optical elements or between the one or more optical elements and the lens array, for enabling the sensor system to perform inline monitoring via the partially transparent mirror, and the one or more optical elements and/or the lens array. These embodiments provide the important advantage of enabling monitoring of the exposure and curing, melting or sintering process during additive manufacturing. The design of an exposure head in accordance with the invention, due to the flatness and small form factor of the various elements, provides little room for additional monitoring equipment such as sensors. Moreover, the lens array, being arranged in between the DMD and the surface of the substrate, would take away a direct line of sight between a sensor and the substrate surface. The present embodiments resolve this by having a partially transparent mirror (e.g. a semitransparent mirror) between the DMD and the lens array. A sensor may then be placed off-axis to monitor the substrate surface through the lens array.

In a second aspect, there is provided an additive manufacturing system comprising an exposure arrangement according to any of the embodiments of the first aspect described above. In various embodiments thereof, the additive manufacturing system is at least one of a group comprising: a powder bed fusion system, such as direct metal laser sintering, electron beam melting, selective heat sintering, selective laser melting and selective laser sintering; or a vat photopolymerization system.

In a third aspect thereof, the present invention is directed at a method of manufacturing an object using an additive manufacturing system, the method comprising illuminating a surface of building material using an exposure system comprising a radiation source configured for providing a radiation beam, a digital micromirror device comprising a mirror array including a plurality of controllable mirrors, and one or more optical elements for directing radiation from the digital micromirror device towards the surface of building material; the method comprising: receiving, by the digital micromirror device, the radiation beam, and forming, by the controllable mirrors, a plurality of illumination beams for illuminating the building material for forming a plurality of voxels, for at least partially curing the building material in each of the voxels; and focusing at least one of the illumination beams onto the surface for forming the voxels, wherein the focusing is performed by a lens array arranged between the one or more optical elements the surface of building material, opposite the surface of building material, wherein the lens array comprises a plurality of lenslets and wherein each lenslet is configured for performing said focusing.

### Brief description of the drawings

The invention will further be elucidated by description of some specific embodiments thereof, making reference to the attached drawings. The detailed description provides examples of possible implementations of the invention, but is not to be regarded as describing the only embodiments falling under the scope. The scope of the invention is defined in the claims, and the description is to be regarded as illustrative without being restrictive on the invention. In the drawings:
Figure 1 is a powder bed fusion system wherein the present invention may be applied;
Figure 2 illustrates a further additive manufacturing system wherein the exposure arrangement in accordance with the present invention may be applied;
Figure 3 illustrates an exposure arrangement in accordance with an embodiment of the present invention;
Figures 4A and 4B illustrate the illumination of a digital micro mirror device (DMD) by a radiation beam in an embodiment in accordance with the present invention;
Figure 5 illustrates a masked microlens array for use with the present invention;
Figure 6 illustrates a square lens array for use in an embodiment of the present invention;
Figure 7 illustrates a further embodiment of an exposure arrangement in accordance with the present invention.

### Detailed description

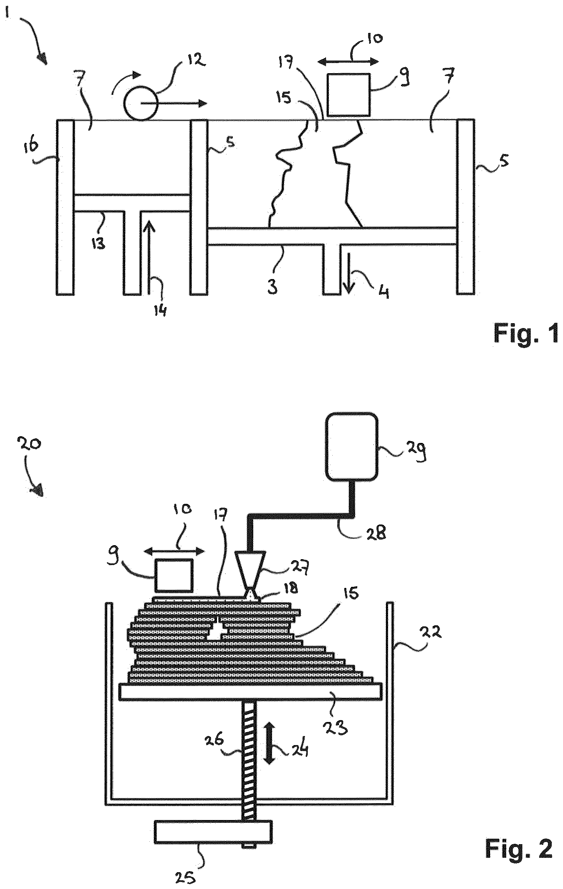

The present invention is directed at an exposure arrangement for use in an additive manufacturing system of arbitrary type, such as the additive manufacturing systems illustrated in figures 1 and 2. The present invention is further directed at a method of manufacturing an object using an additive manufacturing system including an exposure arrangement in accordance with the present invention.

In figure 1 a schematic illustration of a powder bed fusion system is provided. The powder bed fusion system 1 comprises a carrier table 3 that may be lowered (in accordance with arrow 4) using an actuator of some kind. The carrier 3 forms the bottom of a container which is on its side enclosed by walls 5. The carrier table 3 and the walls 5 together form a building area.

Adjacent the building area, a building material feed section consists of walls 5 and 16 and a movable floor 13 that can be raised or lowered (see arrow 14) using an actuator. The building material feed section is filled with building material 7. The building material 7 is a powder or granulate that may be melted and re-cured using optical radiation. From the building material feed section, an applicator 12 in the form of a roller conveys the building material 7 into the building area between the walls 5. To do this, each time new building material 7 needs to be conveyed to the building area, the floor 13 is raised and the applicator 12 rolls across the surface of the building material 7. A bow wave in front of the roller 12 conveys the building material 7 into the building area between the walls 5. There, the building material 7 fills up the space such that it is at level with the upper edges of the walls 5 as illustrated in figure 1. Each time the carrier table 3 is lowered, the building material 7 in the building area between the walls 5 lowers as well, making space for a new layer of building material to be applied by the roller 12.

To create an object in the powder bed fusion system 1 of figure 1, an illumination system 9 is moved across the surface 17 of the building material 7. The illumination system selectively illuminates pixels based on layer data obtained from a memory. The layer data indicates which pixels are to be cured and which pixels do not need to be cured. The pixels in each layer are thereby selectively cured by the exposure system 9 by selectively irradiating each pixel on the surface 17 of the building material 7. This allows to create an object 15 of any desired or arbitrary shape. After a layer has been cured, the carrier table 3 is lowered again and a next layer of fresh building material 7 is applied by the roller 12.

Figure 2 illustrates a different type of additive manufacturing apparatus 20. In the additive manufacturing apparatus 20, a carrier table 23 can be lowered by an actuator 25 operating on axel 26. The direction of movement of the carrier table 23 is indicated by arrow 24 in figure 2. Optionally, the carrier table 23 may be moved up and down a vat or container 22. In some embodiments of such a system, the container 22 may be filled with building material, and lowering of carrier table 23 results in fresh building material to cover the last cured layer of the object 15. In other embodiments, such as the embodiment illustrated in figure 2, fresh building material 8 is applied using an applicator 27. The building material 8 in this case may be a liquid resin or the like. The applicator 27 is fed via a supply line 28 from a supply container 29 filled with building material. The applicator 27 applies a fresh layer 18 of building material that can be selectively cured. Figure 2 further illustrates the exposure arrangement 9 moving across the surface as illustrated by double arrow 10. By selectively curing the pixels of the surface 17 of the layer 18 of building material 8, an object, such as object 15, may be formed.

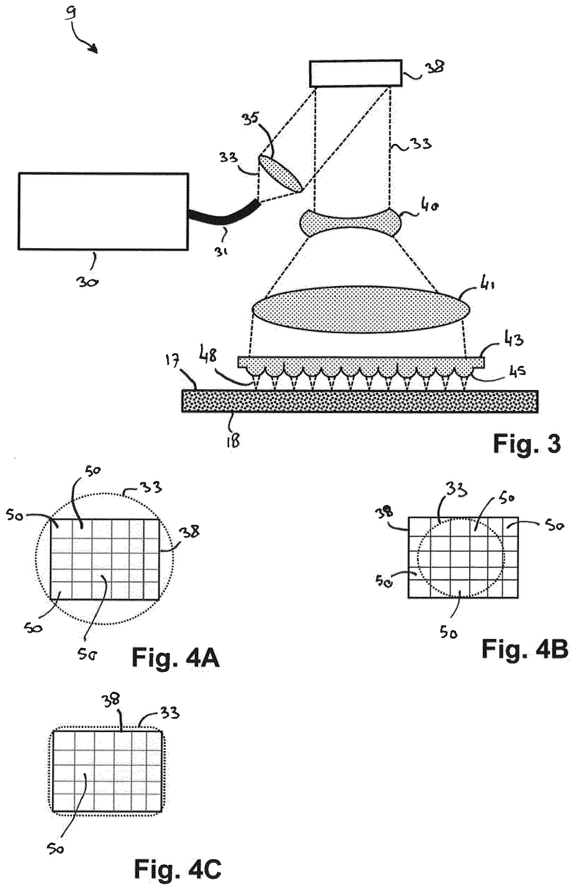

Figure 3 illustrates an exposure arrangement in accordance with an embodiment of the present invention. The exposure arrangement 9 comprises a radiation source 30. The radiation source may be a laser diode. For example the radiation source 30 may be a multimode laser diode which allows to provide a high power laser beam (e.g. 200W). In the embodiment illustrated in figure 3, the laser diode 30 is connected to a fiber 31 that conveys the optical radiation from the radiation source 30 towards the optics of the exposure arrangement. At the output of fiber 31, an optical beam 33 is emitted which falls upon a lens 35 that focuses the beam 33 onto a digital micromirror device (DMD) 38. Optionally, in case sufficient space is available in the exposure arrangement, the radiation source 30 may directly radiate the beam 33 onto the optics 35 or onto the DMD 38. In that case the fiber 31 would be absent.

As illustrated in figure 4A and 4B, it is not critical to the application of the invention whether or not the beam 33 is neatly focused on the DMD 38.In figure 4A, the beam 33 having a circular cross section covers a larger area than the DMD 38. Each mirror 50 of the DMD 38 receives laser light from the beam 33. In figure 4B on the other hand, the DMD is much larger (in terms of surface area) than the cross section of the beam 33. Here, not every mirror 50 of the DMD is fully or partially illuminated by the beam 33. This is not problematic because a DMD device is relatively cheap, and may thus have a surface area that is larger than the beam 33. As may be appreciated, the optics 35 and the beam 33 provided from the fiber 31 of the radiation source 30 may also be arranged for shaping the beam 33 such that it does neatly cover the surface area of the DMD 38. In that case, each mirror of the DMD 38 can be used to reflect the radiation and control the optical radiation for each pixel. This is schematically illustrated in figure 4C, wherein the cross section of the beam 33 is adapted to the surface area of the DMD 38. An advantage of this is that all radian energy of the beam 33 is used efficiently.

Back to figure 3, as briefly described above, each mirror in DMD 38 focusses its reflected radiation via the optics 40 and 41 onto a lens let 45 of the lens array 43. A plurality of mirrors 50 from the DMD 38 may focus their reflected radiation onto a single lens let 45 of the lens array 43. If some of the pixels of the DMD do not function properly (e.g. due to malfunction or dirt) this may be compensated by redistributed radiation reflected by each of the mirrors 50 of the DMD 38 onto the various lens lets 35 of the lens array 43. The bundle of illumination beams provided from the various mirrors 50 of DMD 38 towards the lens array 43 is illustrated in figure 3 as a single beam 33 of optical radiation. The optics 40 and 41 focus the beam 33 onto the lens array 43 and each of the lens lets 45 focusses its received radiation into a pixel on the surface 17 of the upper layer of the building material (7,8). This is illustrated by the cones 48 underneath the lens array 43.

The mirrors 50 of the DMD 38 can be switched into a reflective or dark state. In the dark state, a mirror is tilted such that no radiation of that mirror is reflected towards the lens array 43. In the reflective state, the mirror is correctly oriented such that the radiation is reflected towards the lens array 43. As a result, by controlling the mirrors 50 of the DMD, various pixels on the surface 17 of the substrate can be selectively illuminated or not, to selectively cure the building material 7. The mirrors 50 are controlled on the basis of layer data that is obtained from a memory of the exposure system or an external system. The layer data indicates which pixels are to be illuminated and cured, and which pixels need to be left uncured.

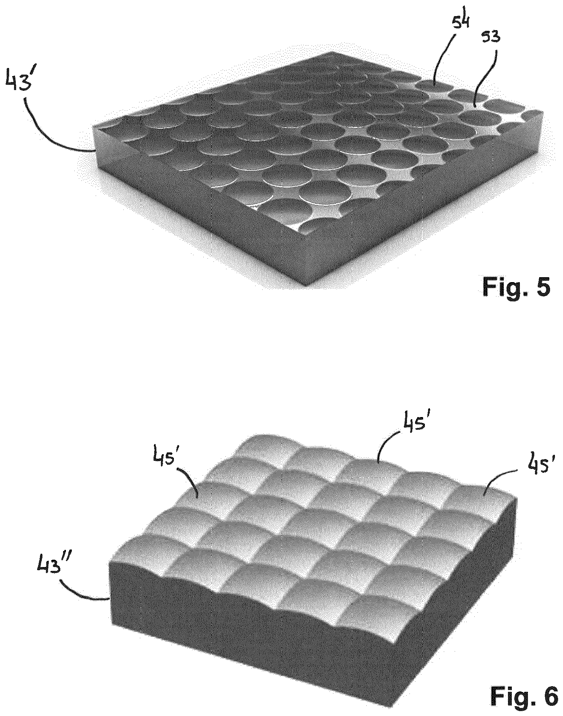

The illumination system of the present invention, for example in accordance with the embodiment illustrated in figure 3, may be used in any type of additive manufacturing system for selectively illuminating the pixels of the building material. If however the additive manufacturing system is a powder bed fusion system, in particular a selective laser centering system, the radiation power required per pixel must be very high in order to selectively melt and cure the building material 7. A selective laser sintering (SLS) apparatus uses laser power to selectively melt and cure for example metal particles, and may thus be used for 3D printing of metals. If the amount of laser power is high, it may be necessary to actively cool the various components of the exposure apparatus. This may be done by installing cooling fins and/or use active gas cooling or active air cooling in between the optical elements. For example cool air may be blown in between the optical elements such as to actively cool the optical elements. As may be appreciated, although this may be sufficient to actively cool the optical elements, this may not be sufficient for all applications. Therefore, in accordance with some embodiments the active cooling is achieved by using liquid cooling or by using actively cooled cooling blocks attached to the housing of the optical components 35, 38, 40, 41 and 43. Yet in other embodiments, the amount of optical radiation may be reduced as much as possible, for example by using masks. A microlens array with mask is illustrated for example in figure 5. The microlens array 43' includes a mask 53 that blocks the radiation in between the lens lets and that transmits the radiation in section 54 such as to enable the radiation to reach the lens lets. As it is the unfocused radiation falling in between lens lets that causes the heating for a large part, a mask may be effective to overcome this problem.

In an alternative embodiment illustrated in figure 6, the lens array may be a square lens array. The advantage of using a square array is that there is hardly any area in between the lenslets that results in suboptimal focusing. Thus, less heat is produced. Also, given the compact structure heat received by the lens array is more easily conveyed towards the sides of the lens array and can be removed by active cooling from the side. In figure 6, the square lens array 43" consists of lenslets 45' in a matrix configuration.

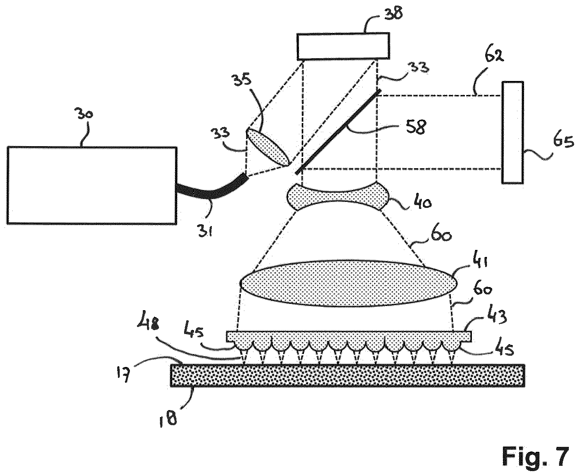

A further embodiment of the exposure arrangement of the present invention is illustrated in figure 7. Here, the elements and parts of the exposure arrangements that are identical to the elements and parts of the embodiment illustrated in figure 3 have received an identical reference numeral, and for a description of these units reference is made to figure 3. In addition to these components, a partially transparent element, such as a semi-transparent mirror or other splitting device, element 58 is placed in between the DMD 38 and the lens array 43. In the embodiment of figure 7 the partially transparent element 58 is illustrated in between DMD 38 and lens 40. However where considered more practical this element may also be present in between any of the other optical elements between DMD 38 and lens array 43.

By doing so, partially transparent element 58 allows to transmit beam 33 towards the lens array 43, but simultaneously allows a free line of sight between inline monitoring sensor system 65 and the substrate surface 17. Inline monitoring sensor system 65 'sees' the semitransparent element 58 as illustrated by line of sight 62. The combined ingress and egress radiation after partially transparent element 38 is indicated by reference numeral 60. Via the optics 40 and 41 and the lens array 43, exposure of the surface 17 of the upper layer 18 of the building material 17 can be actively monitored.

Instead of a sensor system, element 65 may also be a different kind of unit. For example, a further radiation source may be located at element 65 to provide additional radiation to perform heating (e.g. to a temperature below the curing, melting or sintering temperature). The radiation source 30 that provides the beam 33 may then be one of less power, because the combined radiation of both sources 30 and 65 would then allow to perform the curing, melting or sintering. No curing, melting or sintering would take place in case only radiation source 65 would be operated.

The present invention has been described in terms of some specific embodiments thereof. It will be appreciated that the embodiments shown in the drawings and described herein are intended for illustrated purposes only and are not by any manner or means intended to be restrictive on the invention. It is believed that the operation and construction of the present invention will be apparent from the foregoing description and drawings appended thereto. It will be clear to the skilled person that the invention is not limited to any embodiment herein described and that modifications are possible which should be considered within the scope of the appended claims. Also kinematic inversions are considered inherently disclosed and to be within the scope of the invention. Moreover, any of the components and elements of the various embodiments disclosed may be combined or may be incorporated in other embodiments where considered necessary, desired or preferred, without departing from the scope of the invention as defined in the claims.

In the claims, any reference signs shall not be construed as limiting the claim. The term 'comprising' and 'including' when used in this description or the appended claims should not be construed in an exclusive or exhaustive sense but rather in an inclusive sense. Thus the expression 'comprising' as used herein does not exclude the presence of other elements or steps in addition to those listed in any claim. Furthermore, the words 'a' and 'an' shall not be construed as limited to 'only one', but instead are used to mean 'at least one', and do not exclude a plurality. Features that are not specifically or explicitly described or claimed may be additionally included in the structure of the invention within its scope. Expressions such as: "means for ..." should be read as: "component configured for ..." or "member constructed to ..." and should be construed to include equivalents for the structures disclosed. The use of expressions like: "critical", "preferred", "especially preferred" etc. is not intended to limit the invention. Additions, deletions, and modifications within the purview of the skilled person may generally be made without departing from the spirit and scope of the invention, as is determined by the claims. The invention may be practiced otherwise then as specifically described herein, and is only limited by the appended claims.

## Claims

1. Exposure arrangement for an additive manufacturing system, the exposure arrangement comprising a radiation source configured for providing a radiation beam, a digital micromirror device comprising a mirror array including a plurality of controllable mirrors, and one or more optical elements for directing radiation from the digital micromirror device towards a surface of building material in use;
wherein the digital micromirror device is configured for receiving the radiation beam, and wherein the digital micromirror device is configured for forming, by the controllable mirrors, a plurality of illumination beams for illuminating the building material for forming a plurality of voxels, for at least partially curing, melting or sintering the building material in each of the voxels;
wherein the arrangement further comprises a lens array between the one or more optical elements and a location of the surface of building material in use, the lens array being arranged such as to be located opposite the surface of building material, wherein the lens array comprises a plurality of lenslets and wherein each lenslet is configured for focusing at least one of the illumination beams onto the surface, for forming the voxels.

2. Exposure arrangement according to claim 1, wherein the digital micromirror device is configured for forming each of the illumination beams by radiation from one of the controllable mirrors, and providing each lenslet of the lens array with a plurality of the illumination beams.

3. Exposure arrangement according to any of the preceding claims, wherein the radiation source is a multimode laser, such as a multimode laser diode, having an optical output power between 100 milliwatt and 10 kilowatt; preferably between 1 watt and 1 kilowatt; more preferably between 50 watt and 500 watt.

4. Exposure arrangement according to any one or more of the preceding claims, further comprising one or more optical fibers, wherein the radiation source is coupled to the or each optical fiber for providing the radiation beam to the or each optical fiber, and wherein the or each optical fiber is arranged for directing the radiation beam to the digital micromirror device.

5. Exposure arrangement according to any of the preceding claims, wherein the lens array is mounted in the arrangement such as to be replaceable, for enabling replacing of the lens array by a further lens array to enable adapting a resolution of the exposure arrangement.

6. Exposure arrangement according to any one or more of the preceding claims, wherein the controllable mirrors of the digital micromirror device are controllable by
controlling one or more of the controllable mirrors for switching the mirrors off and on in a dark or reflective state.

7. Exposure arrangement according to any one or more of the preceding claims, further comprising a controller configured for controlling at least one of the digital micromirror device, the radiation source, one or more mirrors of the digital micromirror device, or one or more actuators for positioning of at least one of the digital micromirror device, the radiation source or the lens array.

8. Exposure arrangement according to any one or more of the preceding claims, wherein the arrangement further comprises a sensor system for monitoring the surface of the building material, the exposure arrangement further comprising a partially transparent mirror arranged between the digital micromirror device and the one or more optical elements or between the one or more optical elements and the lens array, for enabling the sensor system to perform inline monitoring via the partially transparent mirror, and the one or more optical elements and/or the lens array.

9. Additive manufacturing system comprising an exposure arrangement according to any of the claims 1-8.

10. Additive manufacturing system according to claim 9, wherein the additive manufacturing system is at least one of a group comprising: a powder bed fusion system, such as direct metal laser sintering, electron beam melting, selective heat sintering, selective laser melting and selective laser sintering; or a vat photopolymerization system.

11. Method of manufacturing an object using an additive manufacturing system, the method comprising illuminating a surface of building material using an exposure system comprising a radiation source configured for providing a radiation beam, a digital micromirror device comprising a mirror array including a plurality of controllable mirrors, and one or more optical elements for directing radiation from the digital micromirror device towards the surface of building material;
the method comprising:
receiving, by the digital micromirror device, the radiation beam, and forming, by the controllable mirrors, a plurality of illumination beams for illuminating the building material for forming a plurality of voxels, for at least partially curing the building material in each of the voxels; and
focusing one of the illumination beams onto the surface for forming the voxels, wherein the focusing is performed by a lens array arranged between the one or more optical elements the surface of building material, opposite the surface of building material, wherein the lens array comprises a plurality of lenslets and wherein each lenslet is configured for performing said focusing.
